# EUROPÄISCHE PATENTSCHRIFT

(11) **EP 2 512 210 B1**
(45) Veröffentlichungstag und Bekanntmachung des Hinweises auf die Patenterteilung: **06.03.2019**
(21) Anmeldenummer: 11162231.2
(22) Anmeldetag: 13.04.2011
(51) Int. Cl.: H05K 7/20

(54) **Koppelungssystem zwischen einem Abwärmeerzeuger und einem Abwärmeaufnehmer**
Coupling system between a waste heat generator and a waste heat receiver
Système de couplage entre un émetteur de chaleur d'échappement et un récepteur de chaleur d'échappement

(43) Veröffentlichungstag der Anmeldung: 17.10.2012
(73) Patentinhaber: Siemens Aktiengesellschaft, 80333 München (DE)
(72) Erfinder: Knauer, Hans, 91359 Leutenbach (DE)

(56) Entgegenhaltungen:
- EP-A2- 2 334 161
- WO-A1-2005/101939
- DE-A1- 4 406 564
- DE-A1-102008 012 911
- US-A- 4 772 999

## Beschreibung

Die Erfindung betrifft ein Koppelungssystem als thermische Schnittstelle zwischen einem Abwärmeerzeuger, insbesondere einem Umrichter, und einem Abwärmeaufnehmer, insbesondere einem Kühlkörper, umfassend einen ersten Körper mit einer ersten Kontaktfläche und einen zweiten Körper mit einer zweiten Kontaktfläche, wobei die beiden Kontaktflächen zum Zwecke eines Wärmeaustausches aneinanderliegen.

Die gerätespezifische und betriebszustandsabhängige Verlustleistung eines technischen Gerätes, beispielsweise eines elektronischen Bausteins, bedingt in vielen Fällen einen Wärmestau im Gerät einerseits und in der unmittelbaren Umgebung andererseits, der die Funktionssicherheit und/oder die Lebenserwartung des Gerätes negativ beeinflusst. Daher ist es häufig notwendig, die erzeugte Ab- oder Verlustwärme abzutransportieren und vom Gerät wegzuführen. Hierzu ist das Gerät, welches als Abwärmeerzeuger wirkt, mit einem Abwärmeaufnehmer, typischerweise einem Kühlkörper, zum Zwecke eines Wärmeaustausches verbunden oder gekoppelt. Eine entsprechende Verbindung bzw. ein entsprechendes Koppelungssystem fungiert demzufolge primär als thermische Schnittstelle und sekundär als mechanische Befestigung.

Eine mögliche Lösung zur Verbindung eines Abwärmeerzeugers mit einem Abwärmeaufnehmer ist in der US 4,772,999 beschrieben. Hier ist in den Abwärmeaufnehmer, einer Basisplatte, eine Nut eingearbeitet, über der ein Abwärmeerzeuger, ein Transistor oder ein Thyristor, platziert und mittels einer gewindeformenden Schraube quasi punktuell befestigt wird.

Weiter ist in der DE 44 06 564 A1 eine Koppelung offenbart, durch welche die Kühlleistung angepasst werden kann, indem seitlich an den bereits vorhandenen Abwärmeaufnehmer , einem Kühlkörper, oder seitlich am Abwärmeerzeuger, einem Verstärker, Koppelglieder und Koppelteile vorgesehen sind, die insbesondere als Nut und Feder ausgebildet sind.

Aus der EP 1 128 432 A2 ist eine Verbindung zwischen einem Abwärmeerzeuger mit einer ersten Kontaktfläche und einem Abwärmeaufnehmer mit einer zweiten Kontaktfläche bekannt, bei der die beiden Kontaktflächen aneinanderliegen und der Abwärmeaufnehmer, ein Kühlkörper, mittels Federklammern am Abwärmeerzeuger, einem Halbleitermodul, befestigt ist. Die Federklammern, die in Richtung der Flächennormalen der Kontaktflächen wirken und beide Kontaktflächen aneinanderpressen, sind dabei umfangseitig am Abwärmeerzeuger angeordnet, wodurch der Anpressdruck zwischen den beiden Kontaktflächen im Randbereich der Kontaktflächen verhältnismäßig groß ist und in Richtung des Flächenschwerpunktes hin deutlich abnimmt.

In der WO 2005/101939 A1 ist eine weitere Verbindung zwischen einem Abwärmeerzeuger und einem Abwärmeaufnehmer offenbart, bei der der Abwärmeerzeuger, ein elektronisches Bauteil, ebenfalls umfangseitig gehalten ist. Dabei ist in den Abwärmeaufnehmer, einem Plattenkörper, eine Nut eingearbeitet, in welche ein Haltestück einführbar ist. Zur Befestigung des Abwärmeerzeugers am Abwärmeaufnehmer wird das Haltestück über ein Befestigungsgewinde, also beispielsweise mittels einer Schraube, in der Nut fixiert.

Da einerseits mit einem verringerten Anpressdruck in der Regel auch eine verringerte Effektivität des Wärmeaustausches einhergeht und andererseits ein Großteil der erzeugten Abwärme typischerweise im Bereich um den Flächenschwerpunkt konzentriert ist, erweist sich eine derartige Anpressdruckverteilung als unvorteilhaft. Dennoch ist eine Anordnung von Befestigungselementen im Randbereich zweier Kontaktflächen bei Verbindungen zwischen einem Abwärmeerzeuger und einem Abwärmeaufnehmer üblich. Die Gründe hierfür sind vielfältig. Häufig bedingt zum Beispiel der Aufbau des Abwärmeerzeugers und/oder des Abwärmeaufnehmers eine Bauraumlimitierung und/oder eine schlechte Zugänglichkeit, so dass eine Anordnung von Befestigungselementen im zentralen Bereich der Kontaktflächen nicht ohne Weiteres realisierbar ist. Ergänzend zu den umfangseitig angeordneten Befestigungselementen wird stattdessen in vielen Fällen im zentralen Bereich zwischen den beiden Kontaktflächen ein Füllmaterial, zum Beispiel Wärmeleitpaste, platziert, wodurch die Effektivität des Wärmeaustauschs verbessert wird.

Der Erfindung liegt die Aufgabe zugrunde, ein einfaches und, bezogen auf den Wärmeaustausch, effektives Koppelungssystem anzugeben.

Diese Aufgabe wird erfindungsgemäß durch die Merkmale des Anspruchs 1 gelöst. Die rückbezogenen Ansprüche beinhalten teilweise vorteilhafte und teilweise für sich selbst erfinderische Weiterbildungen dieser Erfindung.

Das Kopplungssystem dient als thermische Schnittstelle zwischen einem Abwärmeerzeuger, insbesondere einem Umrichter, und einem Abwärmeaufnehmer, insbesondere einem Kühlkörper. Es umfasst einen ersten Körper mit einer ersten Kontaktfläche sowie einen zweiten Körper mit einer zweiten Kontaktfläche, wobei die beiden Kontaktflächen zum Zwecke eines Wärmeaustausches aneinanderliegen. Zur Verbindung und zur Verspannung der beiden Kontaktflächen ist eine Nut-Feder-Verbindung mit Federn und in Längsrichtung erstreckenden parallelen Nuten vorgesehen. Von besonderer Bedeutung ist, dass durch die Nut-Feder-Verbindung gleichzeitig die Bauteile gegeneinander zur Erzielung eines guten Flächenkontakts verspannt werden. Hierzu sind die Nuten und die Federn bevorzugt derart ausgebildet, dass durch deren Zusammenfügen eine Anpresskraft in Richtung der Flächennormalen der beiden Kontaktflächen ausgeübt wird.

Eine entsprechende Nut-Feder-Verbindung stellt eine sehr zweckmäßige und einfach zu realisierende mechanische Befestigung dar. Der notwendige Bauraum für die Nut-Feder-Verbindung ist durch eine geeignete Gestaltung von Federn und Nuten an den Aufbau des Abwärmeerzeugers und/oder des Abwärmeaufnehmers anpassbar und beschränkt sich im Wesentlichen auf den Bereich um die Kontaktflächen selbst. Zur Ausbildung der Verbindung ist, im Gegensatz beispielsweise zu einer Verschraubung, kein direkt angreifendes Werkzeug notwendig, wodurch auch kein entsprechender Raum für einen Werkzeugangriff vorzusehen ist. Es ist darüber hinaus auch nicht notwendig, für den Bediener eine unmittelbare Zugänglichkeit zu den Befestigungselementen, also den Nuten und den Federn, im Montageendzustand vorzusehen, so dass diese zugunsten eines möglichst effektiven Wärmeaustausches frei zwischen dem Abwärmeerzeuger und dem Abwärmeaufnehmer im Bereich der Kontaktflächen positioniert werden kann. Da die Verspannung oder Verpressung der beiden Kontaktflächen im Bereich der Nut-Feder-Verbindung am stärksten ist und demzufolge der Wärmeaustausch in diesem Bereich besonders effektiv erfolgt, wird die Nut-Feder-Verbindung bevorzugt in einem Bereich positioniert, in dem die Erzeugung von Abwärme besonders ausgeprägt ist, so dass die Abwärme in eben diesem Bereich auch verstärkt abtransportiert wird. Mit einer derartigen Verbindung ist demzufolge sowohl eine zweckmäßige und einfach zu realisierende mechanische Befestigung als auch eine effektive thermische Schnittstelle gegeben.

Die Federn sind dabei als Nutsteine ausgebildet. Entsprechende Nutsteine lassen sich als separate Bauteile in großen Stückzahlen einfach fertigen und zudem entsprechend dem Baukastenprinzip mit verschiedenen Abwärmeerzeugern bzw. Abwärmeaufnehmern kombinieren. Die Befestigung der Nutsteine erfolgt dabei vorzugsweise mit Hilfe einer lösbaren Verbindung und insbesondere mit Hilfe einer Schraubverbindung. Hierdurch ist im Falle einer Beschädigung eines Nutsteins ein einfacher Austausch möglich.

Einer vorteilhaften Weiterbildung entsprechend ist eine Anzahl von Nutsteinen im Wesentlichen gleichmäßig auf der ersten Kontaktfläche matrixartig verteilt angeordnet, wobei die Anordnung der Nutsteine vorzugsweise matrixartig ist. Da mit Hilfe eines jeden Nutsteins im Zusammenspiel mit der Nut eine Anpresskraft im Bereich des Nutsteins ausgebildet wird, bedingt die gleichmäßige Verteilung der Nutsteine auf der ersten Kontaktfläche eine entsprechend gleichmäßige Anpressdruckverteilung. Der Wärmeaustausch zwischen den Kontaktflächen und in der Folge der gewünschte Abtransport von Abwärme wird hierdurch signifikant verbessert.

Weiter sind mehrere im Wesentlichen parallele Nuten an der zweiten Kontaktfläche vorgesehen. Die parallele Anordnung mehrerer Nuten stellt dabei insbesondere eine zweckdienliche Anpassung an eine matrixartige Anordnung mehrerer Nutsteine dar, wobei eine jede Nut vorzugsweise als Gegenpart für mehrere Nutsteine vorgesehen ist. Diese spezielle Kombination einer matrixartigen Anordnung der Nutsteine und einer parallelen Anordnung mehrerer Nuten eignet sich zum Beispiel auch, um mehrere Abwärmeerzeuger mit einem Abwärmeaufnehmer oder einen Abwärmeerzeuger mit mehreren Abwärmeaufnehmern zu koppeln. Hierdurch ist somit eine Modulbauweise gegeben, die sich auch auf eine größere Anzahl von Abwärmeerzeugern und/oder Abwärmeaufnehmern erweitern lässt.

Darüber hinaus ist es zweckmäßig, wenn eine jede Nut mindestens eine im Vergleich zur normalen Nutbreite verbreiterte Einführöffnung für Nutsteine aufweist. Eine derartige Einführöffnung erleichtert das Einbringen eines Nutsteins in eine Nut und wirkt somit unterstützend bei der Montage.

Weiterhin weisen die Nutsteine einen T-förmigen Querschnitt und die Nuten einen daran angepassten Nutquerschnitt auf. T-artige Nut-Feder-Verbindungen kommen in diversen Anwendungen bereits zum Einsatz, was in Bezug auf den Fertigungsaufwand und die Fertigungskosten auch im Falle der hier vorliegenden speziellen Anwendung von Vorteil ist. Zum Beispiel ist es dadurch möglich, bei den Nutsteinen auf ein bereits vorhandenes Sortiment zurückzugreifen.

Zudem ist an einem Element der Nut-Feder-Verbindung ein Federelement vorgesehen, dessen Rückstellkraft im Montageendzustand im Wesentlichen in Richtung der Flächennormalen der beiden Kontaktflächen wirkt. Die mittels Federelement erzeugte Rückstellkraft soll dabei den Anpressdruck, den die beiden Kontaktflächen aufeinander ausüben, weiter erhöhen und dementsprechend die Effektivität des Wärmeaustausches weiter verbessern.

Entsprechend einer vorteilhaften Weiterbildung weist der Nutstein einen Querschenkel auf und das Federelement ist an der Unterseite des Querschenkels positioniert. Diese Position eignet sich insbesondere für einfach zu fertigende Druckfederelemente, da infolge der Positionierung die Federrückstellkraft wie gewünscht parallel zur Flächennormalen der beiden Kontaktflächen wirksam ist.

Bevorzugt wird zudem eine Ausführung, bei der das Federelement durch eine Blattfeder gegeben ist. Entsprechende Blattfedern sind einerseits einfach in der Herstellung und andererseits äußerst belastbar.

In vorteilhafter Weiterbildung weisen die Blattfedern eine W-ähnliche Form auf. Bei einer solchen W-Form ist das Verhältnis zwischen der Stärke der Rückstellkraft im verformten Zustand und der Ausdehnung der Blattfeder in Richtung der Rückstellkraft im unverformten Zustand besonders günstig.

Weiter ist es zweckdienlich, wenn das Federelement mittels einer formschlüssigen und vorzugsweise lösbaren Verbindung verliersicher fixiert ist. Hierdurch wird einerseits der damit verbundene Montageaufwand gering gehalten und andererseits eine einfache Austauschbarkeit sichergestellt.

Zur Gewährleistung eines möglichst effektiven Wärmeaustausches ist ein verhältnismäßig großer Anpressdruck zwischen den beiden Kontaktflächen vorgesehen, wodurch die Einbringung der Feder in die Nut im Rahmen der Montage erschwert wird. Daher ist für das Kopplungssystem vorzugsweise eine Montagehilfe vorgesehen, die eine in Längsrichtung der Nut wirkende Montagekraft zur Ausbildung der Nut-Feder-Verbindung ausübt. Bevorzugt wird dabei insbesondere eine Lösung, bei der durch eine Kraft-Weg-Umverteilung eine Verringerung des Kraftaufwandes erzielt wird.

Einer bevorzugten Ausgestaltung entsprechend weist die Montagehilfe einen Gewindebolzen und ein Gegengewinde auf, derart dass eine Verdrehung des Gewindebolzens im Gegengewinde eine Verschiebung der beiden Kontaktflächen gegeneinander quer zu deren Flächennormalen und in Längsrichtung der Nut bewirkt. Für den Gewindebolzen ist dabei vorzugsweise ein Werkzeugangriff, zum Beispiel ein Angriff für einen Schraubendreher, vorgesehen, so dass für den Bediener eine möglichst einfache und intuitive Handhabung realisiert ist.

Die Erfindung wird nachfolgend anhand einer Zeichnung näher erläutert. Darin zeigen:
- FIG 1: nach Art einer Explosionsdarstellung ein Koppelungssystem mit einem Umrichter als Abwärmeerzeuger und einem Kühlkörper als Abwärmeaufnehmer,
- FIG 2: in einer perspektivischen Schnittdarstellung den Umrichter und den Kühlkörper im Montageendzustand,
- FIG 3: in einer perspektivischen Ansicht den Umrichter und den Kühlkörper im Montageendzustand,
- FIG 4: in einer perspektivischen Ansicht den Umrichter mit einer Anzahl von montierten Nutsteinen,
- FIG 5: in einer perspektivischen Ansicht einen der Nutsteine,
- FIG 6: die vergrößerte Darstellung VI aus FIG 1,
- FIG 7: in einer vergrößerten Schnittdarstellung den Umrichter und den Kühlkörper im Montageendzustand zusammen mit einer überlappenden Darstellung einer Blattfeder,
- FIG 8: die vergrößerte Darstellung VIII aus FIG 2,
- FIG 9: die vergrößerte Darstellung IX aus FIG 10,
- FIG 10: in einer Draufsicht den Umrichter und den Kühlkörper im Montageendzustand und
- FIG 11: in einer perspektivischen Ansicht den Umrichter und den Kühlkörper in einem Montage-Zwischenschritt-Zustand.

Einander entsprechende Teile sind in allen Figuren mit den gleichen Bezugszeichen versehen.

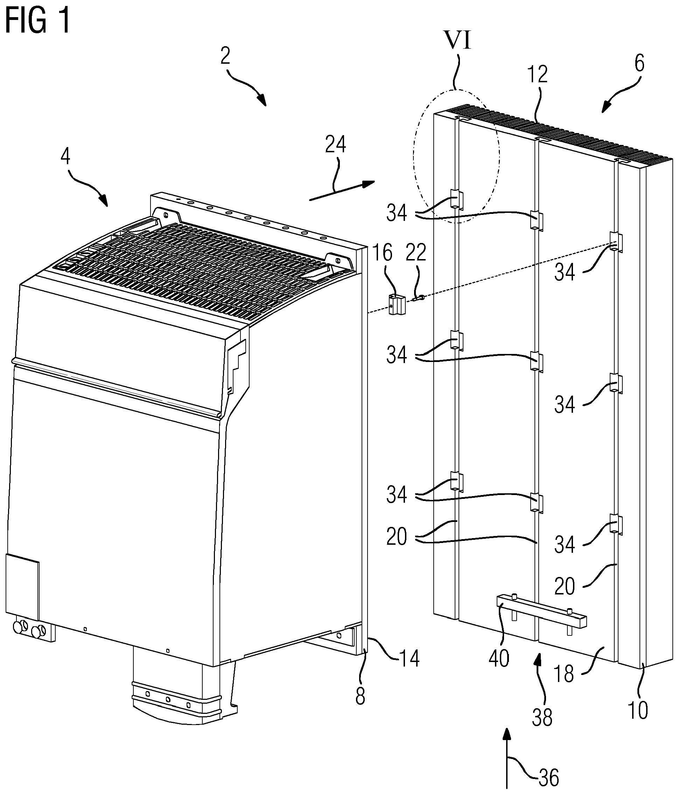

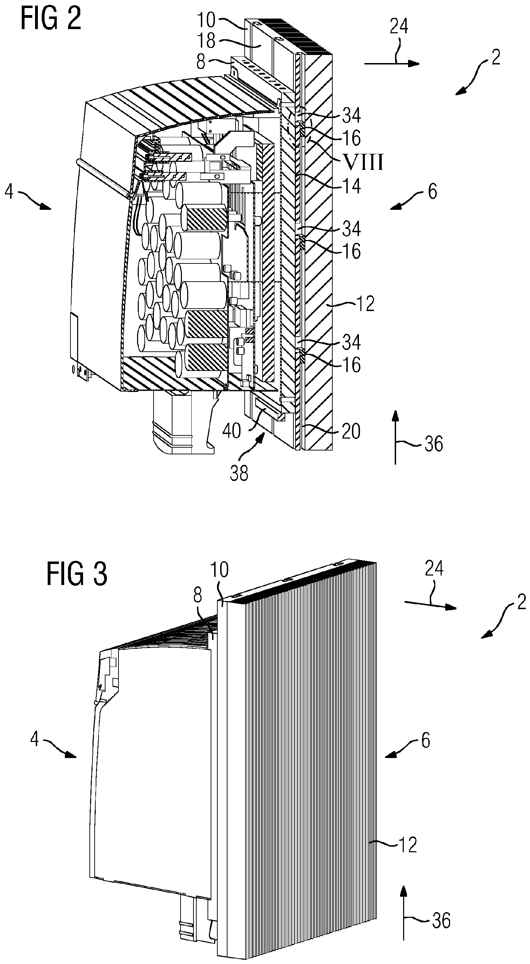

Das nachfolgend beschriebene Kopplungssystem 2, welches in FIG 1 nach Art einer Explosionsdarstellung abgebildet ist, dient im Ausführungsbeispiel als thermische Schnittstelle zwischen einem Umrichter 4 und einem Kühlkörper 6. Der Umrichter 4 wirkt hierbei als Abwärmeerzeuger und weist eine quaderförmige erste Kontaktplatte 8 aus Aluminium auf. Für den Kühlkörper 6, der hier exemplarisch als Abwärmeaufnehmer fungiert, ist eine ebenfalls quaderförmige und aus Aluminium bestehende zweite Kontaktplatte 10 vorgesehen. Im Montageendzustand des Kopplungssystems 2 liegen die beiden Kontaktplatten 8, 10 entsprechend den Darstellungen in FIG 2 und FIG 3 zum Zwecke eines Wärmeaustausches planparallel aneinander. Damit sind die beiden Kontaktplatten 8, 10 sowohl Komponenten des Umrichters 4 bzw. des Kühlkörpers 6 als auch Teil des Kopplungssystems 2. Zur Verbindung und Verspannung der beiden Kontaktplatten 8, 10 sind mehrere Nut-Feder-Verbindungen vorgesehen, so dass das Koppelungssystem 2 im Ausführungsbeispiel durch die beiden Kontaktplatten 8, 10 sowie die Nut-Feder-Verbindungen gegeben ist.

Die vom Umrichter 4 erzeugte Ab- oder Verlustwärme wird in nicht näher dargestellter Weise in die erste Kontaktplatte 8 eingespeist und mittels der thermischen Schnittstelle in die zweite Kontaktplatte 10 weitergeleitet. Aus der zweiten Kontaktplatte 10 erfolgt sodann der Abtransport der Abwärme und damit, entsprechend der Zielvorgabe, die Wegführung der Ab- oder Verlustwärme vom Abwärmeerzeuger. Dies geschieht im Ausführungsbeispiel exemplarisch mit Hilfe einer Anordnung von Kühlrippen 12, welche an die zweite Kontaktplatte 10 angeformt sind.

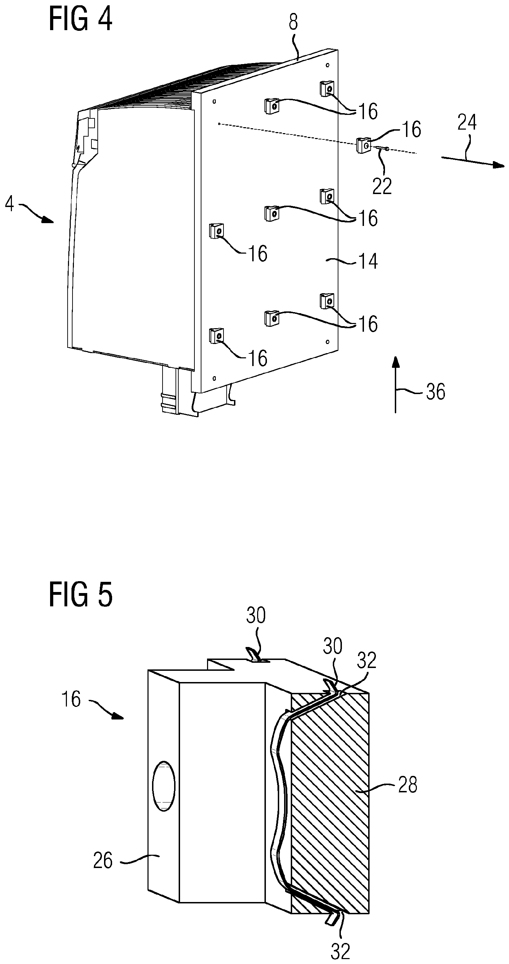

Zur Ausbildung der Nut-Feder-Verbindungen sind an einer ersten Kontaktfläche 14 der ersten Kontaktplatte 8 mehrere Nutsteine 16 und an einer zweiten Kontaktfläche 18 der zweiten Kontaktplatte 10 mehrere Nuten 20 angeordnet. Die Nutsteine 16 bilden dabei, wie in FIG 4 dargestellt, die Ecken eines regelmäßigen Gitters mit einer rechteckigen Elementarzelle ab. Die hier gewählte Anzahl von 9 Nutsteinen 16 stellt eine zweckmäßige Anpassung an den dargelegten Anwendungsfall und insbesondere an die typischen Abmessungen eines Umrichters 4 dar. Fixiert ist ein jeder Nutstein 16 mit Hilfe einer Schraube 22, die den Nutstein 16 in Richtung der Flächennormalen 24 der ersten Kontaktfläche 14 durchsetzt. Dabei ist der Kopf der Schraube 22 im Montageendzustand im Nutstein 16 versenkt angeordnet.

Als Grundform für die Nutsteine 16 dient, wie aus FIG 5 ersichtlich, ein gerades Prisma mit einer T-förmigen Grundfläche. Etwa in der Mitte der Höhe des Prismas ist ein zylinderförmiger Kanal positioniert, der als Aufnahme für die Schraube 22 wirkt und von dieser im Montageendzustand durchsetzt wird. In alternativer Betrachtung wird ein jeder Nutstein 16 durch zwei quaderförmige und senkrecht zueinander angeordnete Teilkörper gebildet, wobei ein Teilkörper als Basis 26 fungiert und im Montageendzustand an der ersten Kontaktfläche 14 anliegt, während der andere Teilkörper als Querschenkel 28 zur Ausbildung der Nut-Feder-Verbindung in der entsprechenden Nut 20 einliegt.

Am Querschenkel 28 sind beiderseits der Basis 26 zwei vorgespannte Blattfedern 30 befestigt, deren Rückstellkraft im Montageendzustand in Richtung der Flächennormalen 24 gerichtet ist. Die Blattfedern 30 sind hierbei identisch gestaltet und weisen eine W-artige Grundform auf. Zur Fixierung liegen die beiden Endabschnitte einer jeden Blattfeder 30 in schlitzförmigen Haltenuten 32 ein, welche schräg aufeinander zulaufend randseitig in die Flanken des Querschenkels 28 eingearbeitet sind. Zudem ragen die Enden einer jeden Blattfeder 30 aus dem Querschenkel 28 heraus und sind widerhakenförmig nach außen abgeknickt, so dass diese jeweils nach Art eines Hintergreifelements wirksam sind.

Als Gegenpart zu den Nutsteinen 16 weist die zweite Kontaktplatte 10 drei parallel zueinander verlaufende Nuten 20 mit einem an die Form der Nutsteine 16 angepassten T-förmigen Querschnitt auf. Weiter sind für eine jede Nut 20 drei quaderförmige Einführöffnungen 34 vorgesehen. Die Abstände zwischen den Einführöffnungen 34 in Längsrichtung 36 der Nuten 20 sowie quer zur Längsrichtung 36 und dementsprechend auch der Abstand der Nuten 20 zueinander entsprechen den Abmessungen der Elementarzelle, die als Grundlage für die Positionierung der Nutsteine 16 relativ zueinander dient.

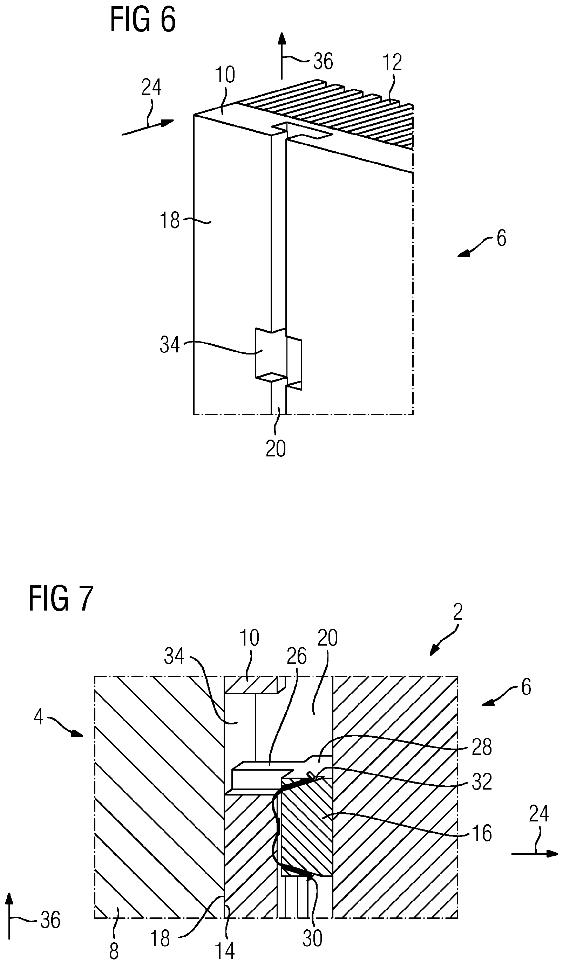

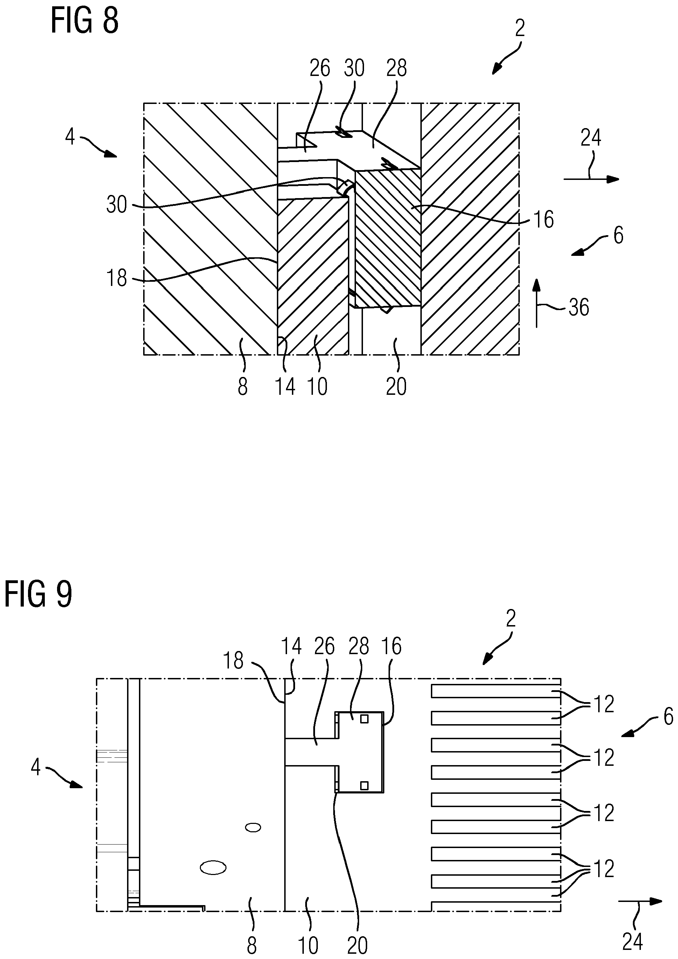

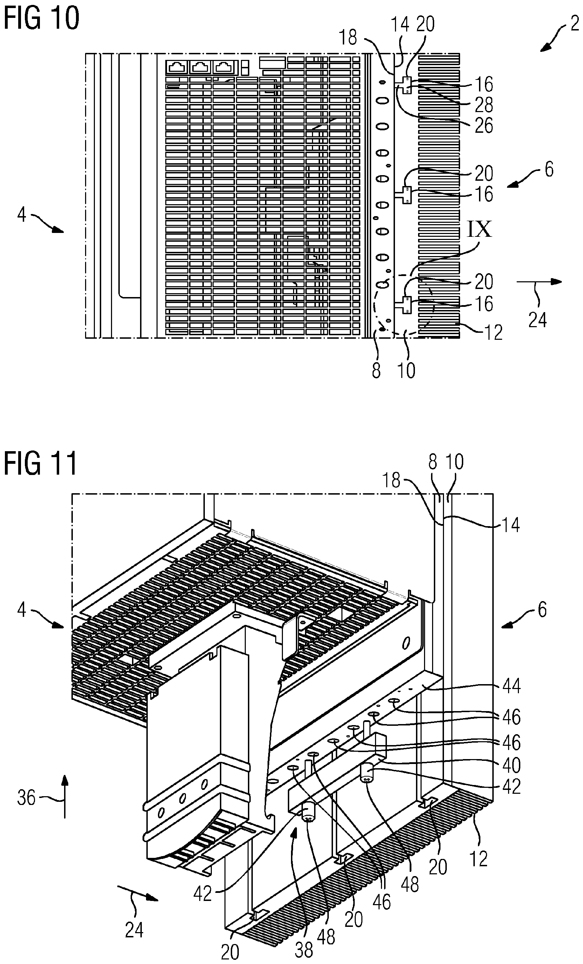

Infolgedessen erfolgt im Rahmen der Montage zunächst eine Annäherung der beiden Kontaktplatten 8,10 in Richtung der Flächennormalen 24, wobei die Nutsteine 16 durch die Einführöffnungen 34 geführt und in der Folge in der zweiten Kontaktplatte 10 versenkt werden. Nun liegen die beiden Kontaktflächen 14, 18 aneinander und durch eine anschließende Verschiebung der beiden Kontaktplatten 8, 10 gegeneinander in Längsrichtung 36 der Nuten 20 werden die Nutsteine 16 sodann in die Nuten 20 eingeführt, so dass in der Folge die Nut-Feder-Verbindungen ausgebildet sind. Diese Situation ist in den Abbildungen FIG 6 bis FIG 10 dargestellt. Bei der Einbringung der Nutsteine 16 in die Nuten 20 werden die Blattfedern 30 weiter gespannt, wobei die Rückstellkraft einer jeden Blattfeder 30 in Richtung der Flächennormalen 24 wirkt, wodurch letzten Endes die beiden Kontaktflächen 14, 18 aneinander gepresst werden.

Da die Effektivität des Wärmeaustausches zwischen den beiden Kontaktplatten 8, 10 mit einem größer werdenden Anpressdruck zwischen den beiden Kontaktflächen 14, 18 zunimmt, ist prinzipiell eine möglichst große Rückstellkraft bei den Blattfedern 30 erwünscht, was jedoch die Einbringung der Nutsteine 16 in die Nuten 20 erschwert. Daher ist für das Kopplungssystem 2 eine Montagehilfe 38 vorgesehen. Hierfür ist an der zweiten Kontaktfläche 18 eine Hilfsleiste 40 angeordnet und fixiert, die von zwei Montageschrauben 42 in Längsrichtung 36 durchsetzt wird. In Ergänzung dazu sind in eine Stirnseite 44 der ersten Kontaktplatte 8 Montagekanäle 46 mit Innengewinde eingearbeitet. Bei der Montage greifen die Montageschrauben 42 in die Montagekanäle 46 ein, so dass durch eine Drehung der Montageschrauben 42 die beiden Kontaktplatten 8,10 gegeneinander in Längsrichtung 36 verschoben werden. Für eine besonders einfache Handhabung ist zudem an den Köpfen der Montageschrauben 42 jeweils ein Werkzeugangriff 48 vorgesehen, der im Ausführungsbeispiel als Innensechskant ausgeführt ist.

Die Erfindung ist nicht auf das vorstehend beschriebene Ausführungsbeispiel beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit dem Ausführungsbeispiel beschriebenen Einzelmerkmale auch auf andere Weise miteinander kombinierbar, ohne den Gegenstand der Erfindung zu verlassen.

## Patentansprüche

1. Koppelungssystem (2) als thermische Schnittstelle zwischen einem Abwärmeerzeuger (4), insbesondere einem Umrichter (4), und einem Abwärmeaufnehmer (6), insbesondere einem Kühlkörper (6), umfassend einen ersten Körper (8) mit einer ersten Kontaktfläche (14) und einen zweiten Körper (10) mit einer zweiten Kontaktfläche (18), wobei
- die beiden Kontaktflächen (14, 18) zum Zwecke eines Wärmeaustausches aneinanderliegen,
- zur Verbindung und zur Verspannung der beiden Kontaktflächen (14,18) eine Nut-Feder-Verbindung mit Federn (16) und sich in Längsrichtung (36) erstreckenden parallelen Nuten (20) genutzt wird und
- die Federn (16) als Nutsteine (16) ausgebildet sind,
- die Nutsteine (16) an der ersten Kontaktfläche (14) fixiert sind,
- die zweite Kontaktfläche (18) die Nuten (20) aufweist
- die Nut-Feder-Verbindung ausgebildet wird, indem die Nutsteine (16) in die Nuten (20) eingeführt werden und
- an einem Element der Nut-Feder-Verbindung ein Federelement (30) positioniert ist, dessen Rückstellkraft im Montageendzustand im Wesentlichen in Richtung der Flächennormalen (24) der beiden Kontaktflächen (14,18) derart wirkt, dass durch die Rückstellkraft der Anpressdruck, den die beiden Kontaktflächen (14,18) aufeinander ausüben, zusätzlich erhöht ist
**dadurch gekennzeichnet, dass**
- die Nutsteine (16) einen T-förmigen Querschnitt aufweisen,
- die Nuten (20) einen an die Form der Nutsteine (16) angepassten T-förmigen Querschnitt aufweisen.

2. Koppelungssystem (2) nach Anspruch 1,
**dadurch gekennzeichnet, dass** eine jede Nut (20) mindestens eine Einführöffnung (34) für Nutsteine (16) aufweist.

3. Koppelungssystem (2) nach Anspruch 1 oder Anspruch 2,
**dadurch gekennzeichnet, dass** ein Nutstein (16) einen Querschenkel (28) aufweist und dass das Federelement (30) an der Unterseite des Querschenkels (28) positioniert ist.

4. Koppelungssystem (2) nach einem der Ansprüche 1 bis 3,
**dadurch gekennzeichnet, dass** eine Blattfeder (30) als Federelement (30) dient.

5. Koppelungssystem (2) nach Anspruch 4,
**dadurch gekennzeichnet, dass** die Blattfeder (30) eine W-ähnliche Form aufweist.

6. Koppelungssystem (2) nach einem der Ansprüche 1 bis 5,
**dadurch gekennzeichnet, dass** das Federelement (30) mittels formschlüssiger Verbindung fixiert ist.

7. Koppelungssystem (2) nach einem der Ansprüche 1 bis 6,
**dadurch gekennzeichnet, dass** eine Montagehilfe (38), durch welche eine Kraft-Weg-Umverteilung zur Verringerung des Kraftaufwandes bei der Montage erzielt wird, zum Einsatz kommt, die eine in Längsrichtung (36) der Nut (20) wirkende Montagekraft zur Ausbildung der Nut-Feder-Verbindung ausübt.

8. Koppelungssystem (2) nach Anspruch 7,
**dadurch gekennzeichnet, dass** die Montagehilfe (38) einen Gewindebolzen (42) und ein Gegengewinde (46) aufweist, derart dass eine Verdrehung des Gewindebolzens (42) im Gegengewinde (46) eine Verschiebung der beiden Kontaktflächen (14,18) gegeneinander quer zu deren Flächennormalen (24) bewirkt.

## Claims

1. Coupling system (2) serving as a thermal interface between a waste-heat generator (4), in particular a converter (4), and a waste-heat receiver (6), in particular a heat sink (6), including a first body (8) having a first contact area (14) and a second body (10) having a second contact area (18), wherein
- the two contact areas (14, 18) are positioned against each other for the purpose of exchanging heat,
- a groove/spring connection having springs (16) and parallel grooves (20) extending in the longitudinal direction (36) is used for connecting and tensioning the two contact areas (14, 18) and
- the springs (16) are embodied as sliding blocks (16),
- the sliding blocks (16) are fixed to the first contact area (14),
- the second contact area (18) has the grooves (20),
- the groove/spring connection is embodied by the sliding blocks (16) being inserted into the grooves (20) and
- positioned on an element of the groove/spring connection is a spring element (30) whose restoring force in the final mounting condition acts substantially in the direction of the surface normals (24) of the two contact areas (14, 18) such that the restoring force causes the clamping pressure exerted by the two contact areas (14, 18) on each other to be additionally increased,
**characterised in that**
- the sliding blocks (16) have a T-shaped cross-section,
- the grooves (20) have a T-shaped cross-section matched to the shape of the sliding blocks (16).

2. Coupling system (2) according to claim 1,
**characterised in that** each groove (20) has at least one insertion opening (34) for sliding blocks (16).

3. Coupling system (2) according to claim 1 or claim 2,
**characterised in that** a sliding block (16) has a crossbar (28) and that the spring element (30) is located on the underside of the crossbar (28).

4. Coupling system (2) according to one of claims 1 to 3,
**characterised in that** a leaf spring (30) is serves as the spring element (30).

5. Coupling system (2) according to claim 4,
**characterised in that** the leaf spring (30) is shaped like a W.

6. Coupling system (2) according to one of claims 1 to 5,
**characterised in that** the spring element (30) is fixed into position by means of a form-fit connection.

7. Coupling system (2) according to one of claims 1 to 6,
**characterised in that** a mounting aid (38), by way of which a force/travel redistribution is achieved during mounting to reduce the force exerted, is employed which exerts a mounting force acting in the longitudinal direction (36) of the groove (20) for embodying the groove/spring connection.

8. Coupling system (2) according to claim 7,
**characterised in that** the mounting aid (38) has a threaded bolt (42) and a counter thread (46) such that twisting the threaded bolt (42) in the counter thread (46) will cause the two contact areas (14, 18) to move against each other transversely to their surface normals (24).

## Revendications

1. Système (2) de couplage, comme interface thermique, entre un producteur (4) de chaleur perdue, notamment un convertisseur (4), et un récepteur (6) de chaleur perdue, notamment un refroidisseur (6), comprenant un premier corps (8), ayant une première surface (14) de contact et un deuxième corps (10) ayant une deuxième surface (18) de contact, dans lequel
- les deux surfaces (14, 18) de contact sont juxtaposées en vue d'un échange de chaleur,
- pour relier et pour bloquer les deux surfaces (14, 18) de contact, il est utilisé un assemblage par rainures et languettes ayant des languettes (16) et des rainures (20) parallèles s'étendant dans la direction (36) longitudinale et
- les languettes (16) sont constituées sous la forme de clavettes (16) rainurées,
- les clavettes (16) rainurées sont immobilisées sur la première surface (14) de contact,
- la deuxième surface (18) de contact a les rainures (20),
- l'assemblage par rainures et languettes est constitué par le fait que les clavettes (16) rainurées sont introduites dans les rainures (20) et
- sur une élément de l'assemblage par rainures et languettes est placé un élément (30) de ressort, dont la force de rappel, dans l'état de montage, agit sensiblement dans la direction des normales (24) aux deux surfaces (14, 18) de contact, de manière à augmenter supplémentairement la force de rappel de la pression d'application que les deux surfaces (14, 18) de contact exercent l'une sur l'autre,
**caractérisé en ce que**
- les clavettes (1) rainurées ont une section transversale en forme de T,
- les rainures (20) ont une section transversale en forme de T adaptée à la forme des clavettes (16) rainurées.

2. Système (2) de couplage suivant la revendication 1,
**caractérisé en ce que** chaque rainure (20) a au moins une ouverture (34) d'entrée de clavette (16) rainurée.

3. Système (2) de couplage suivant la revendication 1 ou la revendication 2,
**caractérisé en ce qu'**une clavette (16) rainurée a une branche (28) transversale et **en ce que** l'élément (30) de ressort est placé sur le côté inférieur de la branche (28) transversale.

4. Système (2) de couplage suivant l'une des revendications 1 à 3,
**caractérisé en ce qu'**un ressort (30) à lame est utilisé comme élément (30) de ressort.

5. Système (2) de couplage suivant la revendication 4,
**caractérisé en ce que** le ressort (30) à lame a une forme semblable à un W.

6. Système (2) de couplage suivant l'une des revendications 1 à 5,
**caractérisé en ce que** l'élément (30) de ressort est immobilisé au moyen d'une liaison à complémentarité de forme.

7. Système (2) de couplage suivant l'une des revendications 1 à 6,
**caractérisé en ce qu'**il est utilisé une aide (38) au montage par laquelle est obtenue une répartition force-parcours pour diminuer la force à appliquer au montage, aide qui, pour constituer l'assemblage par rainures et languettes, applique une force de montage agissant dans la direction (36) longitudinale de la rainure.

8. Système (2) de couplage suivant la revendication 7,
**caractérisé en ce que** l'aide (38) au montage a un boulon (42) fileté et un filetage (46) antagoniste, de manière à ce qu'une torsion du boulon (42) fileté dans le filetage (46) antagoniste, provoque un déplacement des deux surfaces (14, 18) de contact l'une par rapport à l'autre, transversalement à leurs normales (24).
